# EUROPEAN PATENT SPECIFICATION

(11) **EP 1 636 653 B1**
(45) Date of publication and mention of the grant of the patent: **28.12.2011**
(21) Application number: 04752630.6
(22) Date of filing: 19.05.2004
(51) Int. Cl.: G03F 7/075

(54) **ADHESION METHOD USING GRAY-SCALE PHOTOLITHOGRAPHY**
VERKLEBUNGSVERFAHREN MIT GRAUSKALA PHOTOLITHOGRAPHIE
PROCEDE DE COLLAGE PAR PHOTOLITHOGRAPHIE DES ECHELLES DE GRIS

(30) Priority: 23.06.2003 US 480641 P
(43) Date of publication of application: 22.03.2006
(73) Proprietor: Dow Corning Corporation, Midland, MI 48611-0994 (US)
(72) Inventor: GARDNER, Geoffrey, Gilbert - Arizona 85297 (US); LEE, Yeong, Joo, Midland, MI 48642 (US)
(74) Representative: Russell, Lindsey
(86) International application number: PCT/US2004/015641
(87) International publication number: WO 2005/001573

(56) References cited:
- WO-A-02/067292
- WO-A-03/041130
- US-A1- 2002 053 730

## Description

### Field of the Invention

This invention relates to a method for improving adhesion using photolithography to prepare smooth surface films. The method may include plasma treatment of the films and adherends to the films to further improve adhesion. The method is useful in electronics packaging applications.

### Background

Photolithography is a technique in which a substrate is covered with a film of a photopatternable composition, which is a radiation-sensitive material. The film is selectively exposed to radiation, *i.e.*, some portions of the film are exposed to the radiation while other portions remain unexposed. Selectively exposing the film may be performed by placing a photomask between the radiation source and the film. The photomask may be a radiation-transparent material having radiation-opaque patterns formed thereon. In positive resist photolithography, the exposed portions of the film are removed and the unexposed portions are left on the substrate. In negative resist photolithography, the unexposed portions of the film are removed and the exposed portions are left on the substrate.

A drawback associated with photolithography is that after exposure to the radiation, the surface of the film may not be flat. Imperfections, such as edgehills, mesa formations, and waviness may be present. These imperfections can possibly occur in any of several steps within a conventional photolithographic process. For example, if a curing step follows exposure to radiation, migration of material within the film can cause localized, nonuniform swelling of the film. Gray-scale photolithography may be used to address this problem. In gray-scale photolithography, the photomask may have gray levels, in addition to, or instead of the opaque patterns. The gray levels allow different intensities of radiation to pass through the photomask and reach the film.

### Summary of the Invention

This invention relates to a method for improving adhesion of a patterned film to an adherend using photolithography. The method comprises:
(i) photopatterning a film of a photopatternable composition by a process comprising exposing a portion of the film to radiation through a photomask to form an exposed film,
(ii) removing regions of the exposed film with a developing solvent to form a patterned film having a flat surface;
(iii) activating the surface of the patterned film, a surface of an adherend, or both; and
(iv) contacting the adherend with the patterned film to adhere the adherend to the patterned film.

This invention further relates to a product prepared by the method.

### Detailed Description of the Preferred Embodiments

All amounts, ratios, and percentages are by weight unless otherwise indicated. The following is a list of definitions, as used herein.

### Definitions

"Cured" means substantial completion of a chemical process by which molecules are joined together by crosslinking into larger molecules to restrict molecular movements.

"Edgehill" means an area around the perimeter of a film that has a height greater than the remainder of the film.

"Mesa formation" means an area inside the perimeter of a film that has a height greater than the remainder of the film.

"Nonadhesive" means that a polymeric material, such as a cured silicone, would not normally adhere to a substrate without treatment.

"Plasma treatment" means exposing a surface to a gaseous state activated by a form of energy externally applied and includes, but is not limited to, corona discharge, dielectric barrier discharge, flame, low pressure glow discharge, and atmospheric glow discharge treatment. The gas used in plasma treatment may be air, ammonia, argon, carbon dioxide, carbon monoxide, helium, hydrogen, krypton, neon, nitrogen, nitrous oxide, oxygen, ozone, water vapor, combinations thereof, and others. Alternatively, other more reactive gases or vapors may be used, either in their normal state of gases at the process application pressure or vaporized with a suitable device from otherwise liquid states, such as hexamethyldisiloxane, cyclopolydimethylsiloxane, cyclopolyhydrogenmethylsiloxanes, cyclopolyhydrogenmethyl-co-dimethylsiloxanes, reactive silanes, and combinations thereof.

"Soluble" means that certain regions of a film are removed by dissolution in a developing solvent, exposing the underlying surface of a substrate on which the film is applied.

"Substantially insoluble" means that certain regions of a film are not removed by dissolution in a developing solvent to the extent that the underlying surface of a substrate, on which the film is applied, is exposed.

### Method of this Invention

This invention relates to a method for improving adhesion of a patterned film to an adherend using photolithography to prepare a photopatterned film having a flat surface. The method comprises:
(i) photopatterning a film of a photopatternable composition by a process comprising exposing a portion of the film to radiation through a photomask to produce an exposed film;
(ii) removing regions of the exposed film with a developing solvent to form a patterned film having a flat surface;
(iii) activating the surface of the patterned film, a surface of an adherend, or both; and
(iv) contacting the adherend with the patterned film to adhere the adherend to the patterned film.

The film of photopatternable composition may be formed by applying a photopatternable composition to a surface of a substrate using any conventional method, such as spin coating, dipping, spraying, or screen printing. For example, the photopatternable composition may be applied by spin coating at a speed of 500 to 6,000 revolutions per minute (rpm) for 5 to 60 seconds. The volume of photopatternable composition applied in the spin coating method may be 0.1 to 5 milliliters (mL). The spin speed, spin time, and volume of photopatternable composition may be adjusted to produce a film having a thickness of 0.1 to 200 micrometers (µm).

When the photopatternable composition comprises a vehicle, the method may optionally further comprise removing at least a portion of the vehicle from the film after the film is formed. For example, the vehicle may be removed by heating the film at a temperature of 50 to 150 °C for 1 to 5 minutes. Alternatively, the vehicle may be removed by heating the film at a temperature of 80 to 120 °C for 2 to 4 minutes.

### Step (i) Photopatterning the Film

The resulting film is photopatterned to produce an exposed film. The film is photopatterned by a process comprising exposing the film to radiation through a photomask configured to produce a flat surface in the resulting exposed film. A light source that may be used to expose the film to radiation is a medium pressure mercury-arc lamp. The wavelength of the radiation may be 150 to 800 nanometers (nm), alternatively 250 to 450 nm. The dose of radiation may be 0.1 to 5,000 milliJoules per square centimeter (mJ/cm²), and alternatively from 250 to 1,300 mJ/cm².

Depending on the photopatternable composition employed, the photopatterning process may be a negative resist process in which the exposed film comprises non-exposed regions soluble in a developing solvent and exposed regions that are substantially insoluble in the developing solvent. Alternatively, the photopatterning process may be a positive resist process in which the exposed film comprises exposed regions that are soluble in a developing solvent and non-exposed regions that are substantially insoluble in the developing solvent.

The film is exposed to the radiation through a photomask configured to produce a flat surface in the resulting exposed film, e.g., configured to eliminate edgehills or mesa formations. The photomask may be a gray-scale photomask. For example, to eliminate edgehills in a negative resist process, a gray-scale photomask having a lighter gray area around the perimeter of a film and a darker gray area inside the perimeter may be used in the method of this invention. Alternatively, to eliminate mesa formations in a negative resist process, a gray-scale photomask having a lighter gray area inside the perimeter of a film and a darker gray area around the perimeter may be used in the method of this invention.

Radiation exposure may be sufficient to render the exposed regions substantially insoluble in a developing solvent and the non-exposed regions soluble in the developing solvent in the negative resist process (or vice versa in the positive resist process). Alternatively, the exposed film may optionally be heated after radiation exposure, *e.g*., for an amount of time such that the exposed regions are rendered substantially insoluble in the developing solvent, and the non-exposed regions are soluble in the developing solvent in the negative resist process. Whether to heat the exposed film and the exact conditions for heating depend on the type of photopatternable composition used. For example, when a photopatternable hydrosilylation curable silicone composition as described below is used in step (i), the exposed film may be heated at a temperature of 50 to 250 °C for 0.1 to 10 minutes, alternatively heated at a temperature of 100 to 200 °C for 1 to 5 minutes, alternatively heated at a temperature of 135 to 165 °C for 2 to 4 minutes. The exposed film may be heated using conventional equipment such as a hot plate or oven.

### Step (ii) Removing Regions of the Exposed Film with a Developing Solvent

Regions of the exposed film, which are soluble in a developing solvent, are removed with the developing solvent to form a patterned film. In the negative resist process, the non-exposed regions are removed; and in the positive resist process, the exposed regions are removed with the developing solvent. The developing solvent may have from 3 to 20 carbon atoms. Examples of developing solvents include ketones, such as methyl isobutyl ketone and methyl pentyl ketone; ethers, such as n-butyl ether and polyethylene glycol monomethylether; esters, such as ethyl acetate and g-butyrolactone; aliphatic hydrocarbons, such as nonane, decalin, and dodemaye; and aromatic hydrocarbons, such as mesitylene, xylene, and toluene. The developing solvent may be applied by any conventional method, including spraying, immersion, and pooling. Alternatively, the developing solvent may be applied by forming a pool of the solvent on a stationary substrate and then spin-drying the substrate. The developing solvent may be used at a temperature of room temperature to 100 °C. However, the specific temperature will depend on the chemical properties of the solvent, the boiling point of the solvent, the desired rate of pattern formation, and the requisite resolution of the photopatterning process.

The patterned film may optionally be heated after exposure to the developing solvent. Whether the patterned film is heated and the conditions for heating will depend on the type of photopatternable composition selected. For example, when the photopatternable silicone composition described below is used, the patterned film may be heated for an amount of time to achieve maximum crosslink density in the silicone without oxidation or decomposition. The patterned film may be heated at a temperature of 50 to 300 °C for 1 to 300 minutes, alternatively heated at a temperature of 75 to 275 °C for 10 to 120 minutes, alternatively heated at a temperature of 200 to 250 °C for 20 to 60 minutes. The patterned film may be heated using conventional equipment such as a hot plate or oven.

A patterned film may also be produced by applying the photopatternable composition to a surface of a substrate to form a film, exposing a portion of the film to radiation having a wavelength of from 150 to 800 nm to produce an exposed film having non-exposed regions covering a portion of the surface and exposed regions covering the remainder of the surface, heating the exposed film for an amount of time such that the exposed regions are substantially insoluble in a developing solvent and the non-exposed regions are soluble in the developing solvent, removing the non-exposed regions of the heated film with the developing solvent to form a patterned film, and heating the patterned film to cure.

One skilled in the art would be able to select appropriate conditions for photopatterning and removing regions (etching) based on, for example, WO2002/067292.

### Step (iii) Activating Surfaces

Step (iii) comprises activating the surface of the patterned film. Step (iii) may comprise activation treatment of the surface by, for example, plasma treatment, corona treatment, ozone treatment, or flame treatment. When step (iii) includes plasma treatment, the surface of the patterned film may be subjected to plasma treatment, a surface of the adherend may be subjected to plasma treatment, or both the surface of the patterned film and the surface of the adherend may be subjected to plasma treatment.

Plasma treatment of the surface of the patterned film converts the surface properties from being nonadhesive to adhesive. Various types of plasma treatment may be used in the method of this invention, including plasma jet, corona discharge treatment, dielectric barrier discharge treatment, and glow discharge treatment. Glow discharge treatment may be carried out using plasma selected from low pressure glow discharge or atmospheric pressure glow discharge.

Glow discharge plasma treatment may be carried out by low pressure glow discharge plasma in either continuous or pulsed modes. Atmospheric pressure glow discharge plasma treatment may be performed at atmospheric pressure in a continuous process using appropriate atmospheric plasma apparatuses. Other plasma treatments may also be used for surface activation. One skilled in the art would be able to select appropriate plasma treatments without undue experimentation. Plasma treatments are known in the art. For example, U.S. Patents 4,933,060 and 5,357,005 and T.S. Sudarshan, ed., Surface Modification Technologies. An Engineer's Guide, Marcel Dekker, Inc., New York, 1989, Chapter 5, pp. 318-332 and 345-362, disclose plasma treatments.

The exact conditions for activating surfaces will vary depending on various factors such including the choice of adherend, the storage time between activating and contacting surfaces, and the choice of photopatternable composition. For example, the exact conditions for plasma treatment will vary depending on various factors including the choice of adherend, the storage time between plasma treatment and contacting, the type and method of plasma treatment used, design of the plasma chamber used. However, low pressure plasma treatment may be carried out at a pressure of up to atmospheric pressure. Plasma treatment may be carried out at a pressure of at least 6.67 Pa (0.05 torr), alternatively at least 104 Pa (0.78 torr), and alternatively at least 200 Pa (1.5 torr). Plasma treatment may be carried out at a pressure of up to 1.33 kPa (10 torr), alternatively up to 400 Pa (3 torr).

Time for activating surfaces depends on various factors including the choice of adherend and photopatternable composition and the activation treatment selected. For example, time of plasma treatment depends on various factors including the material to be treated, the contact conditions selected, the mode of plasma treatment (e.g., batch or continuous), and the design of the plasma apparatus. Plasma treatment is carried out for a time sufficient to render the surface of the material to be treated sufficiently reactive to form an adhesive bond. Plasma treatment is carried out for a time of at least 0.001 second, alternatively at least 0.002 second, alternatively at least 0.1 second, alternatively at least 1 second, alternatively at least 5 seconds. Plasma treatment is carried out for up to 30 minutes, alternatively up to 1 minute, alternatively up to 30 seconds. It may be desirable to minimize plasma treatment time for commercial scale process efficiency. Treatment times that are too long may render some treated materials nonadhesive or less adhesive.

Environment for activating surfaces depends on various factors including the choice of adherend and photopatternable composition and the activation treatment selected. For example, the gas used in plasma treatment may be, for example, air, ammonia, argon, carbon dioxide, carbon monoxide, helium, hydrogen, nitrogen, nitrous oxide, oxygen, ozone, water vapor, combinations thereof, and others. Alternatively, the gas may be selected from air, argon, carbon dioxide, carbon monoxide, helium, nitrogen, nitrous oxide, ozone, water vapor, and combinations thereof. Alternatively, the gas may be selected from air, argon, carbon dioxide, helium, nitrogen, ozone, and combinations thereof. Alternatively, other more reactive organic gases or vapors may be used, either in their normal state of gases at the process application pressure or vaporized with a suitable device from otherwise liquid states, such as hexamethyldisiloxane, cyclopolydimethylsiloxane, cyclopolyhydrogenmethylsiloxanes, cyclopolyhydrogenmethyl-co-dimethylsiloxanes, reactive silanes, combinations thereof, and others.

One skilled in the art would be able to select appropriate activation treatment conditions without undue experimentation using the above guidelines and, for example, the disclosure of WO 2003/41130.

### Step (iv) Contacting the Patterned Film and the Adherend

The resulting activated surface of the patterned film and the adherend may be contacted with each other as soon as practicable after activation. A surface of the adherend may also be activated. Alternatively, the patterned film and the adherend may optionally each be stored independently after activation and before contacting

The exact conditions for step (iv) will vary depending on the adherend selected, whether the surface of the adherend is activated, and the ingredients of the photopatternable composition, however, adhesion may be obtained by performing step (iv) for a few seconds at ambient temperature. Alternatively, step (iv) may be performed at elevated temperature, elevated pressure, or both. The exact conditions selected for step (iv), will depend on various factors including the specific photopatternable composition and the adherend selected.

### Substrates

The adherend used in step (iv) is another substrate that may comprise the same or a different material as the substrate on which the photopatternable composition is applied. The substrate and the adherend used in this method are not specifically restricted. The substrate and the adherend selected will depend on various factors including the use of the method described above, e.g., the type of electronic device or electronic device package to be fabricated. The substrate and the adherend may comprise any materials used in the fabrication of an electronic device or an electronic device package. Suitable substrates and adherends include, but are not limited to, semiconductors and articles that are useful in electronics applications to which semiconductors may be attached.

Semiconductors are known in the art and commercially available, for example, see J. Kroschwitz, ed., "Electronic Materials," Kirk-Othmer Encyclopedia of Chemical Technology, 4th ed., vol. 9, pp. 219-229, John Wiley & Sons, New York, 1994. Common semiconductors include silicon, silicon alloys, and gallium arsenide. The semiconductor may have any convenient form, such as a bare die, a chip such as an integrated circuit (IC) chip, or a wafer.

Articles that are useful in electronics applications include ceramics, metals and metal coated surfaces, polymers, porous materials, combinations thereof, and others. Ceramics include but are not limited to aluminum nitride, aluminum oxide, silicon carbide, silicon oxide, silicon nitride, silicon oxynitride, and combinations thereof. Metals and metal coatings include aluminum, chromium, copper, gold, iron, lead, nickel, platinum, silver, solder, stainless steel, tin, titanium, and their alloys.

Suitable polymers include but are not limited to, acrylic polymers; acrylonitrile-butadiene-styrenes; benzocyclobutenes; bismaleimides; cyanates; epoxies; fluorocarbon polymers such as polytetrafluoroethylene and polyvinylfluoride; polyamides such as Nylon; polyamide resin blends, such as blends of polyamide resins with syndiotactic polystyrene such as those commercially available from the Dow Chemical Company, of Midland, Michigan, U.S.A.; polybenzoxazoles; poly(butylene terephthalate) resins; polycarbonates; polyesters; polyimides; polymethylmethacrylates; polyolefins such as polyethylene and polypropylene; polyphenylene ethers; polyphthalamides; poly(phenylene sulfides); polystyrene; polyvinylidene chlorides; styrene-modified poly(phenylene oxides), vinyl esters; and combinations thereof.

Porous materials include but are not limited to paper, wood, leather, fabrics, and combinations thereof. Other articles include, but are not limited to painted surfaces, glass, glass cloth, and combinations thereof.

### Photopatternable Composition

The photopatternable composition used in the method of this invention is not specifically restricted. Examples of suitable photopatternable compositions include photopatternable silicone compositions and photopatternable organic compositions. Suitable photopatternable silicone compositions are exemplified by photopatternable hydrosilylation curable silicone compositions, photopatternable epoxy-functional silicone compositions, and (meth)acrylate-functional photopatternable silicone compositions. Suitable organic photopatternable compositions are exemplified by (meth)acrylates, epoxies, polyimides, which are commercially available from Toray Industries, Inc. of Japan, polybenzoxazoles, which are commercially available from Sumitomo of Japan, and benzocyclobutenes, which are commercially available from The Dow Chemical Company of Midland, Michigan, U.S.A.

An example of a photopatternable hydrosilylation curable silicone composition used in the method of this invention comprises:
(A) an organopolysiloxane containing an average of at least two silicon-bonded unsaturated organic groups per molecule,
(B) an organosilicon compound containing an average of at least two silicon-bonded hydrogen atoms per molecule in a concentration sufficient to cure the composition, and
(C) a catalytic amount of a photoactivated hydrosilylation catalyst.

### Component (A)

Component (A) comprises at least one organopolysiloxane containing an average of at least two silicon-bonded unsaturated organic groups capable of undergoing a hydrosilylation reaction per molecule, such as alkenyl groups. The organopolysiloxane may have a linear, branched, or resinous structure. The organopolysiloxane may be a homopolymer or a copolymer. The unsaturated organic groups may have 2 to 10 carbon atoms and are exemplified by, but not limited to, alkenyl groups such as vinyl, allyl, butenyl, and hexenyl. The unsaturated organic groups in the organopolysiloxane may be located at terminal, pendant, or both terminal and pendant positions.

The remaining silicon-bonded organic groups in the organopolysiloxane are organic groups free of aliphatic unsaturation. These organic groups may be independently selected from monovalent hydrocarbon and monovalent halogenated hydrocarbon groups free of aliphatic unsaturation. These monovalent groups may have from 1 to 20 carbon atoms, alternatively 1 to 10 carbon atoms, and are exemplified by, but not limited to alkyl such as methyl, ethyl, propyl, pentyl, octyl, undecyl, and octadecyl; cycloalkyl such as cyclohexyl; aryl such as phenyl, tolyl, xylyl, benzyl, and 2-phenylethyl; and halogenated hydrocarbon groups such as 3,3,3-trifluoropropyl, 3-chloropropyl, and dichlorophenyl. At least 50 percent, alternatively at least 80%, of the organic groups free of aliphatic unsaturation in the organopolysiloxane may be methyl.

The viscosity of the organopolysiloxane at 25 °C varies with molecular weight and structure, but may be 0.001 to 100,000 Pascal seconds (Pa·s), alternatively 0.01 to 10,000 Pa·s, and alternatively 0.01 to 1,000 Pa·s.

Examples of organopolysiloxanes useful in the photopatternable hydrosilylation curable silicone composition include, but are not limited to, polydiorganosiloxanes having the following formulae: ViMe₂SiO(Me₂SiO)ₐSiMe₂Vi,

ViMe₂SiO(Me₂SiO)_{0.25a}(MePhSiO)_{0.75a}SiMe₂Vi,

ViMe₂SiO(Me₂SiO)_{0.95a}(Ph2SiO)_{0.05a}SiMe₂Vi,

ViMe₂SiO(Me₂SiO)_{0.95a}(MeViSiO)_{0.02a}SiMe₂Vi, Me₃SiO(Me₂SiO)_{0.95a}(MeViSiO)_{0.05a}SiMe₃, and PhMeViSiO(Me₂SiO)ₐSiPhMeVi, where Me, Vi, and Ph denote methyl, vinyl, and phenyl respectively and subscript a has a value such that the viscosity of the polydiorganosiloxane is 0.001 to 100,000 Pa·s.

Methods of preparing organopolysiloxanes suitable for use in the photopatternable hydrosilylation curable silicone composition, such as hydrolysis and condensation of the corresponding organohalosilanes or equilibration of cyclic polydiorganosiloxanes, are known in the art.

Examples of organopolysiloxane resins include an MQ resin consisting essentially of R¹₃SiO_{1/2} units and SiO_{4/2} units, a TD resin consisting essentially of R¹SiO_{3/2} units and R¹₂SiO_{2/2} units, an MT resin consisting essentially of R¹₃SiO_{1/2} units and R¹SiO_{3/2} units, and an MTD resin consisting essentially of R¹₃SiO_{1/2} units, R¹SiO_{3/2} units, and R¹₂SiO_{2/2} units, wherein each R¹ is independently selected from monovalent hydrocarbon and monovalent halogenated hydrocarbon groups. The monovalent groups represented by R¹ may have 1 to 20 carbon atoms, alternatively 1 to 10 carbon atoms.

Examples of monovalent groups for R¹ include, but are not limited to, alkyl such as methyl, ethyl, propyl, pentyl, octyl, undecyl, and octadecyl; cycloalkyl such as cyclohexyl; alkenyl such as vinyl, allyl, butenyl, and hexenyl; aryl such as phenyl, tolyl, xylyl, benzyl, and 2-phenylethyl; and halogenated hydrocarbon groups such as 3,3,3-trifluoropropyl, 3-chloropropyl, and dichlorophenyl. At least one-third, and alternatively substantially all R1 groups in the organopolysiloxane resin may be methyl. An exemplary organopolysiloxane resin consists essentially of (CH₃)₃SiO_{1/2} siloxane units and SiO_{4/2} where the mole ratio of (CH₃)₃SiO_{1/2} units to SiO_{4/2} units is 0.6 to 1.9.

The organopolysiloxane resin may contain an average of 3 to 30 mole percent of unsaturated organic groups capable of undergoing a hydrosilylation reaction, such as alkenyl groups. The mole percent of unsaturated organic groups in the resin is the ratio of the number of moles of unsaturated organic group-containing siloxane units in the resin to the total number of moles of siloxane units in the resin, multiplied by 100.

The organopolysiloxane resin may be prepared by methods known in the art. For example, the organopolysiloxane resin may prepared by treating a resin copolymer produced by the silica hydrosol capping process of Daudt et al. with at least an alkenyl-containing endblocking reagent. The method of Daudt et al, is disclosed in U.S. Patent 2,676,182.

Briefly stated, the method of Daudt et al. involves reacting a silica hydrosol under acidic conditions with a hydrolyzable triorganosilane such as trimethylchlorosilane, a siloxane such as hexamethyldisiloxane, or combinations thereof, and recovering a copolymer having M and Q units. The resulting copolymers may contain 2 to 5 percent by weight of hydroxyl groups.

The organopolysiloxane resin, which may contain less than 2 percent by weight of silicon-bonded hydroxyl groups, may be prepared by reacting the product of Daudt et al. with an alkenyl-containing endblocking agent or a mixture of an alkenyl-containing endblocking agent and an endblocking agent free of aliphatic unsaturation in an amount sufficient to provide 3 to 30 mole percent of alkenyl groups in the final product. Examples of endblocking agents include, but are not limited to, silazanes, siloxanes, and silanes. Suitable endblocking agents are known in the art and are exemplified in U.S. Patents 4,584,355; 4,591,622; and 4,585,836. A single endblocking agent or a mixture of endblocking agents may be used to prepare the organopolysiloxane resin.

Component (A) may be a single organopolysiloxane or a combination comprising two or more organopolysiloxanes that differ in at least one of the following properties: structure, viscosity, average molecular weight, siloxane units, and sequence.

### Component (B)

Component (B) is at least one organosilicon compound containing an average of at least two silicon-bonded hydrogen atoms per molecule. It is generally understood that crosslinking occurs when the sum of the average number of alkenyl groups per molecule in component (A) and the average number of silicon-bonded hydrogen atoms per molecule in component (B) is greater than four. The silicon-bonded hydrogen atoms in the organohydrogenpolysiloxane may be located at terminal, pendant, or at both terminal and pendant positions.

The organosilicon compound may be an organosilane or an organohydrogensiloxane. The organosilane may be a monosilane, disilane, trisilane, or polysilane. Similarly, the organohydrogensiloxane may be a disiloxane, trisiloxane, or polysiloxane. The organosilicon compound may an organohydrogensiloxane or the organosilicon compound may be an organohydrogenpolysiloxane. The structure of the organosilicon compound may be linear, branched, cyclic, or resinous. At least 50 percent of the organic groups in the organosilicon compound may be methyl.

Examples of organosilanes include, but are not limited to, monosilanes such as diphenylsilane and 2-chloroethylsilane; disilanes such as 1,4-bis(dimethylsilyl)benzene, bis[(p-dimethylsilyl)phenyl]ether, and 1,4-dimethyldisilylethane; trisilanes such as 1,3,5-tris(dimethylsilyl)benzene and 1,3,5-trimethyl-1,3,5-trisilane; and polysilanes such as poly(methylsilylene)phenylene and poly(methylsilylene)methylene.

Examples of organohydrogensiloxanes include, but are not limited to, disiloxanes such as 1,1,3,3-tetramethyldisiloxane and 1,1,3,3-tetraphenyldisiloxane; trisiloxanes such as phenyltris(dimethylsiloxy)silane and 1,3,5-trimethylcyclotrisiloxane; and polysiloxanes such as a trimethylsiloxy-terminated poly(methylhydrogensiloxane), a trimethylsiloxy-terminated poly(dimethylsiloxane/methylhydrogensiloxane), a dimethylhydrogensiloxy-terminated poly(methylhydrogensiloxane), and a resin consisting essentially of H(CH₃)₂SiO_{1/2} units, (CH₃)₃SiO_{1/2} units, and SiO_{4/2} units.

Component (B) may be a single organosilicon compound or a combination comprising two or more such compounds that differ in at least one of the following properties: structure, average molecular weight, viscosity, silane units, siloxane units, and sequence.

The concentration of component (B) in the photopatternable hydrosilylation curable silicone composition of the present invention is sufficient to cure (crosslink) the composition. The exact amount of component (B) depends on the desired extent of cure, which generally increases as the ratio of the number of moles of silicon-bonded hydrogen atoms in component (B) to the number of moles of unsaturated organic groups in component (A) increases. The concentration of component (B) may be sufficient to provide from 0.5 to 3 silicon-bonded hydrogen atoms per alkenyl group in component (A). Alternatively, the concentration of component (B) is sufficient to provide 0.7 to 1.2 silicon-bonded hydrogen atoms per alkenyl group in component (A).

Methods of preparing organosilicon compounds containing silicon-bonded hydrogen atoms are known in the art. For example, organopolysilanes may be prepared by reaction of chlorosilanes in a hydrocarbon solvent in the presence of sodium or lithium metal (Wurtz reaction). Organopolysiloxanes may be prepared by hydrolysis and condensation of organohalosilanes.

To ensure compatibility of components (A) and (B), the predominant organic group in each component may be the same.

### Component (C)

Component (C) is a photoactivated hydrosilylation catalyst. The photoactivated hydrosilylation catalyst may be any hydrosilylation catalyst capable of catalyzing the hydrosilylation of component (A) with component (B) upon exposure to radiation having a wavelength of from 150 to 800 nanometers (nm) and subsequent heating. The platinum group metals include platinum, rhodium, ruthenium, palladium, osmium and iridium. The platinum group metal may be platinum due to its high activity in hydrosilylation reactions. The suitability of particular photoactivated hydrosilylation catalyst for use in the photopatternable hydrosilylation curable silicone composition may be determined by routine experimentation using the methods in the Examples section below.

Examples of photoactivated hydrosilylation catalysts include, but are not limited to, platinum(II) b-diketonate complexes such as platinum(II) bis(2,4-pentanedioate), platinum(II) bis(2,4-hexanedioate), platinum(II) bis(2,4-heptanedioate), platinum(II) bis(1-phenyl-1,3-butanedioate, platinum(II) bis(1,3-diphenyl-1,3-propanedioate), platinum(II) bis(1,1,1,5,5,5-hexafluoro-2,4-pentanedioate); (h-cyclopentadienyl)trialkylplatinum complexes, such as (Cp)trimethylplatinum, (Cp)ethyldimethylplatinum, (Cp)triethylplatinum, (chloro-Cp)trimethylplatinum, and (trimethylsilyl-Cp)trimethylplatinum, where Cp represents cyclopentadienyl; triazene oxide-transition metal complexes, such as Pt[C₆H₅NNNOCH₃]₄, Pt[p-CN-C₆H₄NNNOC₆H₁₁]₄, Pt[p-H₃COC₆H₄NNNOC₆H₁₁]₄, Pt[p-CH₃(CH₂)b-C₆H₄NNNOCH₃]₄, 1,5-cyclooctadiene.Pt[p-CN-C₆H₄NNNOC₆Hₙ]₂,1,5-cyclooctadiene.Pt[p-CH₃O-C₆H₄NNNOCH₃]₂, [(C₆H₅)₃P]₃Rh[p-CN-C₆H₄NNNOC₆H₁₁], and Pd[p-CH₃(CH₂)b-C₆H₄NNNOCH₃]₂, where b is 1, 3, 5, 11, or 17; (η-diolefin)(σ-aryl)platinum complexes, such as (η⁴-1,5-cyclooctadienyl)diphenylplatinum, h4-1,3,5,7-cyclooctatetraenyl)diphenylplatinum, (η⁴-2,5-norboradienyl)diphenylplatinum, (η⁴-1,5-cyclooctadienyl)bis-(4-dimethylaminophenyl)platinum, (η⁴-1,5-cyclooctadienyl)bis-(4-acetylphenyl)platinum, and (η⁴-1,5-cyclooctadienyl)bis-(4-trifluormethylphenyl)platinum. Alternatively, the photoactivated hydrosilylation catalyst is a Pt(II) b-diketonate complex, and alternatively the catalyst is platinum(II) bis(2,4-pentanedioate).

Component (C) may be a single photoactivated hydrosilylation catalyst or a combination comprising two or more such catalysts.

The concentration of component (C) is sufficient to catalyze the hydrosilylation reaction of components (A) and (B) upon exposure to radiation and heat in the method described herein. The concentration of component (C) may be sufficient to provide 0.1 to 1000 parts per million (ppm) of platinum group metal, alternatively 0.5 to 100 ppm of platinum group metal, alternatively 1 to 25 ppm of platinum group metal, based on the combined weight of components (A), (B), and (C). The rate of cure may be slow below 1 ppm of platinum group metal. The use of more than 100 ppm of platinum group metal may result in no appreciable increase in cure rate, which would be uneconomical.

Methods of preparing the photoactivated hydrosilylation catalysts are known in the art. For example, methods of preparing platinum(II) β-diketonates are reported by Guo et al. (Chemistry of Materials, 1998, 10, 531-536). Methods of preparing (η-cyclopentadienyl)trialkylplatinum complexes and are disclosed in U.S. Patent 4,510,094. Methods of preparing triazene oxide-transition metal complexes are disclosed in U.S. Patent 5,496,961. Methods of preparing (η-diolefin)(σ-aryl)platinum complexes are disclosed in U.S. Patent No. 4,530,879.

### Optional Components

The photopatternable hydrosilylation curable silicone composition may further comprise one or more optional components, provided the optional component does not adversely affect the photopatterning or cure of the composition in the method of this invention. Examples of optional components include, but are not limited to, (D) an inhibitor, (E) a filler, (F) a treating agent for the filler, (G) a vehicle, (H) a spacer, (I) an adhesion promoter, (J) a surfactant, (K) a photosensitizer, (L) colorants such as a pigment or dye, and combinations thereof.

### Component (D)

Combinations of components (A), (B), and (C) may begin to cure at ambient temperature. To obtain a longer working time or "pot life", the activity of the catalyst under ambient conditions may be retarded or suppressed by the addition of (D) an inhibitor to the photopatternable hydrosilylation curable silicone composition. A platinum group catalyst inhibitor retards curing of the present photopatternable hydrosilylation curable silicone composition at ambient temperature, but does not prevent the composition from curing at elevated temperatures. Suitable platinum catalyst inhibitors include various "ene-yne" systems such as 3-methyl-3-penten-1-yne and 3,5-dimethyl-3-hexen-1-yne; acetylenic alcohols such as 3,5-dimethyl-1-hexyn-3-ol, 1-ethynyl-1-cyclohexanol, and 2-phenyl-3-butyn-2-ol; maleates and fumarates, such as the well known dialkyl, dialkenyl, and dialkoxyalkyl fumarates and maleates; and cyclovinylsiloxanes.

The concentration of platinum catalyst inhibitor in the photopatternable hydrosilylation curable silicone composition is sufficient to retard curing of the composition at ambient temperature without preventing or excessively prolonging cure at elevated temperatures. This concentration will vary depending on the particular inhibitor used, the nature and concentration of the hydrosilylation catalyst, and the nature of the organohydrogenpolysiloxane. However, inhibitor concentrations as low as one mole of inhibitor per mole of platinum group metal may yield a satisfactory storage stability and cure rate. Inhibitor concentrations of up to 500 or more moles of inhibitor per mole of platinum group metal may be used. One skilled in the art would be able to determine the optimum concentration for a particular inhibitor in a particular silicone composition by routine experimentation.

### Component (E)

Component (E) is a filler. Component (E) may comprise a thermally conductive filler, a reinforcing filler, or combinations thereof. The thermally conductive filler may be thermally conductive, electrically conductive, or both. Alternatively, component (E) may be thermally conductive and electrically insulating. Suitable thermally conductive fillers for component (E) include metal particles, metal oxide particles, and a combination thereof. Suitable thermally conductive fillers for component (E) are exemplified by aluminum nitride; aluminum oxide; barium titinate; beryllium oxide; boron nitride; diamond; graphite; magnesium oxide; metal particulate such as copper, gold, nickel, or silver; silicon carbide; tungsten carbide; zinc oxide, and combinations thereof.

Thermally conductive fillers are known in the art and commercially available, see for example, U.S. Patent 6,169,142 (col. 4, lines 7-33). For example, CB-A20S and A1-43-Me are aluminum oxide fillers of differing particle sizes commercially available from Showa-Denko, and AA-04, AA-2, and AA18 are aluminum oxide fillers commercially available from Sumitomo Chemical Company.

Silver filler is commercially available from Metalor Technologies U.S.A. Corp. of Attleboro, Massachusetts, U.S.A. Boron nitride filler is commercially available from Advanced Ceramics Corporation, Cleveland, Ohio, U.S.A.

Reinforcing fillers include silica, and chopped fiber, such as chopped KEVLAR®.

A combination of fillers having differing particle sizes and different particle size distributions may be used as component (E). For example, it may be desirable to combine a first filler having a larger average particle size with a second filler having a smaller average particle size in a proportion meeting the closest packing theory distribution curve. This improves packing efficiency and may reduce viscosity and enhance heat transfer.

### Component (F)

The filler for component (E) may optionally be surface treated with component (F) a treating agent. Treating agents and treating methods are known in the art, see for example, U.S. Patent 6,169,142 (col. 4, line 42 to col. 5, line 2).

The treating agent may be an alkoxysilane having the formula: R³_{c}Si(OR⁴)_{(4-c)}, where c is 1, 2, or 3; alternatively c is 3. R³ is a substituted or unsubstituted monovalent hydrocarbon group of at least 1 carbon atom, alternatively at least 8 carbon atoms. R3 has up to 50 carbon atoms, alternatively up to 30 carbon atoms, alternatively up to 18 carbon atoms. R³ is exemplified by alkyl groups such as hexyl, octyl, dodecyl, tetradecyl, hexadecyl, and octadecyl; and aromatic groups such as benzyl, phenyl and phenylethyl. R³ may be saturated or unsaturated, branched or unbranched, and unsubstituted. R³ may be saturated, unbranched, and unsubstituted.

R⁴ is an unsubstituted, saturated hydrocarbon group of at least 1 carbon atom. R⁴ may have up to 4 carbon atoms, alternatively up to 2 carbon atoms. Component C) is exemplified by hexyltrimethoxysilane, octyltriethoxysilane, decyltrimethoxysilane, dodecyltrimethyoxysilane, tetradecyltrimethoxysilane, phenyltrimethoxysilane, phenylethyltrimethoxysilane, octadecyltrimethoxysilane, octadecyltriethoxysilane, a combination thereof, and others.

Alkoxy-functional oligosiloxanes may also be used as treatment agents. Alkoxy-functional oligosiloxanes and methods for their preparation are known in the art, see for example, EP 1 101 167 A2. For example, suitable alkoxy-functional oligosiloxanes include those of the formula (R⁷O)_{d}Si(OSiR⁵₂R⁶)_{4-d}. In this formula, d is 1, 2, or 3, alternatively d is 3. Each R⁵ is may be independently selected from saturated and unsaturated monovalent hydrocarbon groups of 1 to 10 carbon atoms. Each R⁶ may be a saturated or unsaturated monovalent hydrocarbon group having at least 11 carbon atoms. Each R⁷ may be an alkyl group.

Metal fillers may be treated with alkylthiols such as octadecyl mercaptan and others, and fatty acids such as oleic acid, stearic acid, titanates, titanate coupling agents, zirconate coupling agents, a combination thereof, and others.

Treatment agents for alumina or passivated aluminum nitride could include alkoxysilyl functional alkylmethyl polysiloxanes (*e.g.*, partial hydrolysis condensate of R⁸ₑR⁹_{f}Si(OR¹⁰)_{(4-e-f)} or cohydrolysis condensates or mixtures), similar materials where the hydrolyzable group would be silazane, acyloxy or oximo. In all of these, a group tethered to Si, such as R⁸ in the formula above, is an unsaturated monovalent hydrocarbon or monovalent aromatic-functional hydrocarbon. R⁹ is a monovalent hydrocarbon group, and R¹⁰ is a monovalent hydrocarbon group of 1 to 4 carbon atoms. In the formula above, e is 1, 2, or 3 and f is 0, 1, or 2, with the proviso that e + f is 1, 2, or 3. One skilled in the art could optimize a specific treatment to aid dispersion of the filler by routine experimentation.

### Component (G)

Component (G) is a vehicle such as a solvent or diluent. Component (G) may be added during preparation of the photopatternable hydrosilylation curable silicone composition, for example, to aid mixing and delivery. All or a portion of component (G) may optionally be removed after the photopatternable hydrosilylation curable silicone composition is prepared or applied to a substrate. One skilled in the art could determine the optimum concentration of a particular vehicle in the photopatternable hydrosilylation curable silicone composition by routine experimentation.

Component (G) may comprise at least one organic solvent to lower the viscosity of the composition and facilitate the preparation, handling, and application of the composition. Examples of suitable solvents include, but are not limited to, the developing solvents described above, saturated hydrocarbons having from 1 to 20 carbon atoms; aromatic hydrocarbons such as xylenes and mesitylene; mineral spirits; halohydrocarbons; esters; ketones; silicone fluids such as linear, branched, and cyclic polydimethylsiloxanes; and mixtures of such vehicles.

### Component (H)

Component (H) is a spacer. Spacers may comprise organic particles, inorganic particles, or a combination thereof. Spacers may be thermally conductive, electrically conductive, or both. Spacers may have a particle size of at least 25 micrometers up to 250 micrometers. Spacers may comprise monodisperse beads. Spacers are exemplified by, but not limited to, polystyrene, glass, perfluorinated hydrocarbon polymers, and combinations thereof. Spacers may be added in addition to, or instead of, all or a portion of the filler.

### Component (I)

Component (I) is an adhesion promoter. Component (I) may comprise a transition metal chelate, an alkoxysilane, a combination of an alkoxysilane and a hydroxy-functional polyorganosiloxane, or a combination thereof.

Component (I) may be an unsaturated or epoxy-functional compound. Suitable epoxy-functional compounds are known in the art and commercially available, see for example, U.S. Patents 4,087,585; 5,194,649; 5,248,715; and 5,744,507 col. 4-5. Component (I) may comprise an unsaturated or epoxy-functional alkoxysilane. For example, the functional alkoxysilane may have the formula R¹¹_{g}Si(OR¹²)_{(4-g)}, where g is 1, 2, or 3, alternatively g is 1.

Each R¹¹ is independently a monovalent organic group with the proviso that at least one R¹¹ is an unsaturated organic group or an epoxy-functional organic group. Epoxy-functional organic groups for R¹¹ are exemplified by 3-glycidoxypropyl and (epoxycyclohexyl)ethyl. Unsaturated organic groups for R¹¹ are exemplified by 3-methacryloyloxypropyl, 3-acryloyloxypropyl, and unsaturated monovalent hydrocarbon groups such as vinyl, allyl, hexenyl, undecylenyl.

Each R¹² is independently an unsubstituted, saturated hydrocarbon group of at least 1 carbon atom. R¹² may have up to 4 carbon atoms, alternatively up to 2 carbon atoms. R¹² is exemplified by methyl, ethyl, propyl, and butyl.

Examples of suitable epoxy-functional alkoxysilanes include 3-glycidoxypropyltrimethoxysilane, 3-glycidoxypropyltriethoxysilane, (epoxycyclohexyl)ethyldimethoxysilane, (epoxycyclohexyl)ethyldiethoxysilane and combinations thereof. Examples of suitable unsaturated alkoxysilanes include vinyltrimethoxysilane, allyltrimethoxysilane, allyltriethoxysilane, hexenyltrimethoxysilane, undecylenyltrimethoxysilane, 3-methacryloyloxypropyl trimethoxysilane, 3-methacryloyloxypropyl triethoxysilane, 3-acryloyloxypropyl trimethoxysilane, 3-acryloyloxypropyl triethoxysilane, and combinations thereof.

Component (I) may comprise an epoxy-functional siloxane such as a reaction product of a hydroxy-terminated polyorganosiloxane with an epoxy-functional alkoxysilane, as described above, or a physical blend of the hydroxy-terminated polyorganosiloxane with the epoxy-functional alkoxysilane. Component (I) may comprise a combination of an epoxy-functional alkoxysilane and an epoxy-functional siloxane. For example, component (I) is exemplified by a mixture of 3-glycidoxypropyltrimethoxysilane and a reaction product of hydroxy-terminated methylvinylsiloxane with 3-glycidoxypropyltrimethoxysilane, or a mixture of 3-glycidoxypropyltrimethoxysilane and a hydroxy-terminated methylvinylsiloxane, or a mixture of 3-glycidoxypropyltrimethoxysilane and a hydroxy-terminated methyvinyl/dimethylsiloxane copolymer. When used as a physical blend rather than as a reaction product, these components may be stored separately in multiple-part kits.

Suitable transition metal chelates include titanates, zirconates such as zirconium acetylacetonate, aluminum chelates such as aluminum acetylacetonate, and combinations thereof. Transition metal chelates and methods for their preparation are known in the art, see for example, U.S. Patent 5,248,715, EP 0 493 791 A1, and EP 0 497 349 B1.

The photopatternable hydrosilylation curable silicone composition of this invention may be a one-part composition comprising components (A) through (C) in a single part or, alternatively, a multi-part composition comprising components (A) through (C) in two or more parts. In a multi-part composition, components (A), (B), and (C) are typically not present in the same part unless an inhibitor is also present. For example, a multi-part photopatternable hydrosilylation curable silicone composition may comprise a first part containing a portion of component (A) and a portion of component (B) and a second part containing the remaining portion of component (A) and all of component (C).

The one-part photopatternable hydrosilylation curable silicone composition of the instant invention may be prepared by combining components (A) through (C) and any optional components in the stated proportions at ambient temperature with or without the aid of a vehicle, which is described above. Although the order of addition of the various components is not critical if the photopatternable hydrosilylation curable silicone composition is to be used immediately, component (C) may be added last at a temperature below 30 °C to prevent premature curing of the composition. The multi-part photopatternable hydrosilylation curable silicone composition of the present invention may be prepared by combining the particular components designated for each part.

When a multi-part composition is prepared, it may be marketed as a kit. The kit may further comprise information or instructions or both as how to use the kit, how to combine the parts, or how to cure the resulting combination, or combinations thereof. One skilled in the art would be able to select suitable photopatternable compositions for use in the method of this invention based on the disclosures of WO 2003/41130 and WO2002/067292.

### Methods of Use

The method described above may be used to prepare adhesive bonds that resist thermal treatment in absence or presence of water in the form of vapor or liquid, or mechanical stress, or both. The adhesion property may be used to hold dissimilar material together. The method may be used in any device in which a hermetic seal is desired.

The method may be used during fabrication of electronic devices and electronic device packages. Electronic devices and methods for their fabrication are known in the art. For example, the electronic device may be a chip on board (COB), wherein the semiconductor is an IC chip, which is mounted directly on a substrate, such as a printed wiring board (PWB) or printed circuit board (PCB). COBs and methods for their fabrication are known in the art, for example, see Basic Integrated Circuit Technology Reference Manual, R.D. Skinner, ed., Integrated Circuit Engineering Corporation, Scottsdale, Arizona, Chapter 3.

The method described above may be used in fabricating any electronic device package in which a semiconductor such as an IC chip is attached to an adherend such as a chip carrier. For example, the method may be used to bond the chip carrier to the cured silicone layer, thereby forming an interposer. The method may also be used to bond the IC chip to the cured silicone either before or after the cured silicone is bonded to the chip carrier. Alternatively, the method may be used to bond the IC chip to the cured silicone only, and an alternative method may be used to bond the cured silicone to the chip carrier.

Electronic device packages and methods for their fabrication are known in the art. For example, the method described above may be used in the fabrication of area array packages and leadframe packages. Area array packages include ball grid arrays, pin grid arrays, chip scale packages, and others. Leadframe packages include chip scale packages and others. Area array packages and leadframe packages, and methods for their fabrication, are known in the art, for example, see U.S. Patent No. 5,858,815.

The method described above may be used in the fabrication of chip scale packages. Chip scale packages, and methods for their fabrication, are known in the art, for example, see U.S. Patent No. 5,858,815.

This invention may be used in the fabrication of single chip modules (SCM), multichip modules (MCM), or stacked chip modules. SCM, MCM, and stacked chip modules, and methods for their fabrication, are known in the art, see, for example, Basic Integrated Circuit Technology Reference Manual, R.D. Skinner, ed., Integrated Circuit Engineering Corporation, Scottsdale, Arizona, Chapter 3.

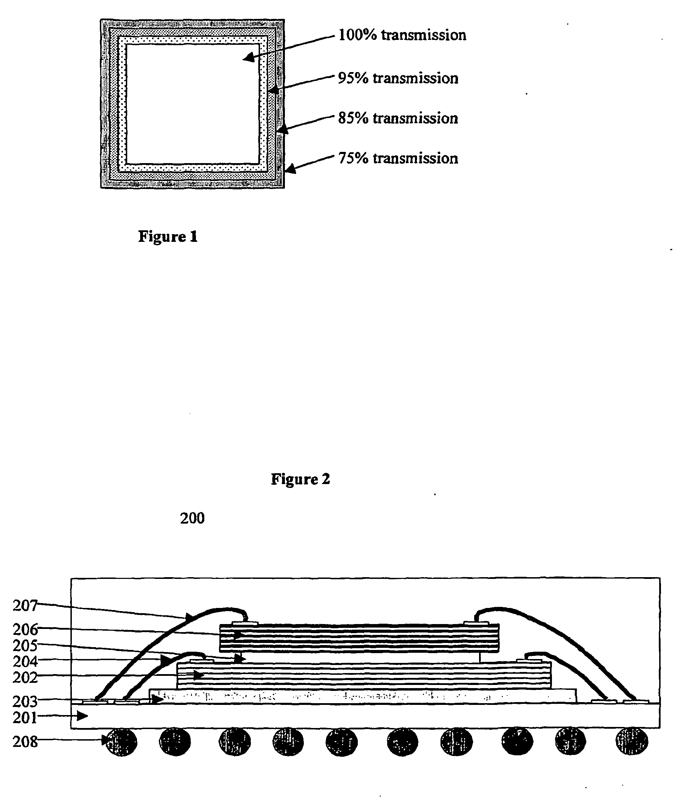

An example of a stacked chip module 200 is shown in Figure 2. The stacked chip module 200 includes a substrate 201 having a first IC chip 202 bonded to the substrate 201 through die attach adhesive 203. The first IC chip 202 is electrically connected to the substrate 201 through wires 204. A photopatterned die attach adhesive 205 is applied to the first IC chip 202. A second IC chip 206 is attached to the photopatterned die attach adhesive 205 by the method of this invention. The second IC chip 206 is electrically connected to the substrate through wires 207. The substrate 201 has solder balls 208 on the surface opposite the die attach adhesive 203.

Wafer level packaging methods are known in the art, for example, see U.S. Patent No. 5,858,815. However, one skilled in the art would recognize that the method of this invention is not limited to use in wafer level packaging may be used in other packaging methods, such as chip level packaging, as well.

Alternatively, the method can be used to make micro devices, such as microelectromechanical devices (MEMs) and microoptoelectromechanical devices (MOEMs), and microfluidic devices. One such micro device is a bonded composite wherein the polymeric material can be, for example, cured silicone and a substrate can be, for example, cured silicone, other materials, and combinations thereof. These composites can have various forms including laminates or three-dimensional (3-D) objects. In one embodiment, a composite structure comprising a cured silicone as a polymeric material and a solid material as a substrate is prepared, wherein only a part of the surface of the solid material is coated with the cured silicone, and the surroundings are not stained with a low molecular weight organopolysiloxane. The 3-D objects can have added functionality like thermal or electrical transfer by means of adding special fillers. The method may be used as to pretreat components of composites prior to or during assembly or to create fiber interphase adhesion, such as for optical fibers. The thin bondline created by plasma treatment should allow adhesion and electrical and thermal conductivity. Examples of microfluidic devices that can be fabricated using this invention are known in the art, for example, see "Fabrication of microfluidic systems in poly(dimethylsiloxane)", McDonald, J. Cooper; Duffy, David C.; Anderson, Janelle, R.; Chiu, Daniel T.; Wu, Hongkai; Shueller, Olivier J. A.; and Whitesides, George, M. in Electrophoresis 2000, 21, 27-40.

In an alternative embodiment of the invention, the method can be used in optoelectronics and photonics applications. The method will adhere optical components with low reflective losses. The optical components can comprise a wide range of materials, the majority of which have low optical transmission losses. Optical materials include silicone elastomers, silica optical fibers, silicone gels, silicone resin lenses, silicon, and others. These materials can be used in photonics devices, such as telecommunications systems. The method provides the ability to adhere a range of materials in situ, and with low reflective losses. Such plasma adhered interfaces may be less prone to thermally induced stresses, leading to improved reliability during temperature cycling (i.e., reduced stress build up and delamination). Plasma treatment can provide a uniform bond over complex surfaces. The method could also be used to improve light efficiency in Flat Panel Displays (bonding of color filter assembly). The method of this invention is advantageous in these applications because it avoids the need for adhesives, which may introduce a separate refractive index, introduce reflective interfaces, and increased absorption.

The method of this invention may also be used for wafer bonding applications.

### Examples

These examples are intended to illustrate the invention to one skilled in the art and should not be interpreted as limiting the scope of the invention set forth in the claims.

### Comparative Example 1

A photopatternable formulation is prepared by mixing 71% vinyl functional silicone resin, 29% polydimethylsiloxane having both silicon bonded vinyl groups and silicon bonded hydrogen atoms, and 20 parts per million of a photoactivated hydrosilylation catalyst. The formulation is applied to a silicon wafer by spin coating. The resulting film has a thickness of 20 micrometers. 5 x 5 millimeter pads are photopatterned with a standard photomask. The surface of the resulting cured silicone layer has edgehills around the perimeter. The edgehills are up to 20% taller than the average thickness of the remainder of the cured silicone layer.

The surface of the cured silicone layer is plasma treated for 10 seconds (s) in air at 100 Watts. The resulting plasma treated surface is contacted with a 5 x 5 millimeter (mm) silicon die (also treated at 10 s, 100 Watts) at room temperature. The adhesion between the cured silicone layer and the silicon die is measured by die shear. Die shear value is less than 3.5 kilograms (Kg). Interfacial contact between surfaces of the resulting patterned film (*i.e.*, pad) and the silicon die is less than 10%.

### Example 1

Comparative example 1 is repeated except that instead of using a standard photomask, a gray-scale binary photomask is used. The gray-scale binary photomask is designed such that the perimeter of the pad receives a reduced amount of irradiation during photolithography. More specifically, the photomask defines a 5 x 5 mm pad as a series of squares of decreasing transmission from 100% to 75% transmission, with every additional square dropping in intensity as shown in Figure 1. The intensities from 95% to 75% are in 50 µm bands and the intensity is controlled within each band by pixels that are 0.5µm in size. Intensity is modulated between the bands by increasing the population of randomly placed opaque 1 µm pixels across each band.

The resulting patterned film (i.e., pad) has reduced surface unevenness (reduced edgehills) as compared to comparative example 1. Interfacial contact is greater than 80%. Die shear value is greater than 20 Kg.

### Comparative Example 2

A photopatternable formulation is prepared by mixing 64% vinyl functional silicone, 36% polydimethylsiloxane having both silicon bonded vinyl groups and silicon bonded hydrogen atoms, and 20 parts per million of a photoactivated hydrosilylation catalyst. The formulation is applied to a silicon wafer and photopatterned as in comparative example 1. The edgehills are up to 20% higher than the thickness of the remainder of the resulting patterned film (*i.e.*, pad).

The resulting patterned film (i.e., pad) and the silicon die contacted as in comparative example 1 and measured by die shear. Die shear values obtained are less than 5 kg. Interfacial contact between surfaces of the cured silicone layer and the silicon die is less than 10%.

### Example 2

Comparative example 2 is repeated except that the gray-scale photomask designed such that the perimeter of the pad receives a reduced amount of irradiation during photolithography is used as in example 1. The resulting patterned film (*i.e.*, pad) has reduced surface unevenness (reduced edgehills) as compared to comparative example 2. Interfacial contact is greater than 80%. Die shear value is greater than 20 Kg.

### DRAWINGS

Figure 1 is a gray-scale photomask used in examples 1 and 2 of this invention.

Figure 2 is a device fabricated using the method of this invention.

### Reference Numerals

- 200: stacked chip module
- 201: substrate
- 202: first IC chip
- 203: die attach adhesive
- 204: wires
- 205: photopatterned die attach adhesive
- 206: second IC chip
- 207: wires
- 208: solder balls

## Claims

1. A method comprismg:
(i) photopatterning a film of a photopatternable composition by a process comprising exposing the film to radiation through a gray-scale photomask;
(ii) removing regions of the exposed film with a developing solvent to form a patterned film having a flat surface;
(iii) activating the surface of the patterned film, a surface of an adherend, or both; and
(iv) contacting the adherend with the patterned film to adhere the adherend to the patterned film.

2. The method of claim 1, where the photopatternable composition comprises (a) a photopatternable silicone composition or (b) an organic photopatternable composition.

3. The method of claim 1, where the photopatternable composition comprises a photopatternable hydrosilylation curable silicone composition, a photopatternable epoxy-functional silicone composition, a (meth)acrylate-functional photopatternable silicone composition, a (meth)acrylate, an epoxy, a cyanate ester, a polyimide, a polybenzoxazole, or a benzocyclobutene.

4. The method of claim 1, where the photopatternable composition comprises a photopatternable hydrosilylation curable silicone composition comprising:
(A) an organopolysiloxane containing an average of at least two silicon-bonded unsaturated organic groups per molecule,
(B) an organosilicon compound containing an average of at least two silicon-bonded hydrogen atoms per molecule in a concentration sufficient to cure the composition, and
(C) a catalytic amount of a photoactivated hydrosilylation catalyst.

5. The method of claim 4, where the composition further comprises one or more of (D) an inhibitor, (E) a filler, (F) a treating agent, (G) a vehicle, (H) a spacer, (I) an adhesion promoter, (J) a surfactant, (K) a photosensitizer, (L) a colorant, or a combination thereof.

6. The method of claim 1, where the film is formed prior to step (i) by a process comprising spin coating, dipping, spraying, or screen printing the photopatternable composition on a surface of a substrate.

7. The method of claim 6, where the composition further comprises component (G) a vehicle and where the method further comprises removing at least a portion of component (G) from the film before step (i).

8. The method of claim 1, where the radiation has a wavelength of 150 to 800 nm in step (i).

9. The method of claim 1, where the exposed film comprises exposed regions that are substantially insoluble in the developing solvent and non-exposed regions that are soluble in the developing solvent.

10. The method of claim 1, where the exposed film comprises exposed regions that are soluble in the developing solvent and non-exposed regions that are substantially insoluble in the developing solvent.

11. The method of claim 1, further comprising heating the exposed film after step (i) and before step (ii).

12. The method of claim 1, further comprising heating the patterned film after step (ii) and before step (iii).

13. The method of claim 1, where step (iii) is carried out by a process comprising plasma treatment, corona treatment, ozone treatment, or flame treatment.

14. The method of claim 1, where the surface is activated using plasma treatment selected from plasma jet, corona discharge treatment, dielectric barrier discharge treatment, and glow discharge treatment.

15. The method of claim 1, where step (iii) comprises plasma treatment the surface on the patterned film, and the method further comprises plasma treatment of a surface of the adherend before step (iv).

16. A product obtainable by the method of claim 1 where the product is selected from the group consisting of a chip on board device, a multichip module, a single chip module, a stacked chip module, a chip scale package, an area array package, a leadframe package, a microelectromechanical device, a microoptoelectromechanical device, and a microfluidic device.

17. The method of claim 1 comprising:
(a) applying a photopatternable composition to a surface of a substrate to form a film, wherein the photopatternable composition comprises:
(A) an organopolysiloxane containing an average of at least two silicon-bonded unsaturated organic groups per molecule,
(B) an organosilicon compound containing an average of at least two silicon-bonded hydrogen atoms per molecule in a concentration sufficient to cure the composition, and
(C) a catalytic amount of a photoactivated hydrosilylation catalyst;
(b) exposing a portion of the film to radiation having a wavelength of from 150 to 800 nm through a gray-scale photomask to produce an exposed film having non-exposed regions covering at least a portion of the surface;
(c) heating the exposed film for an amount of time such that the exposed regions are substantially insoluble in a developing solvent and the non-exposed regions are soluble in the developing solvent;
(d) removing the non-exposed regions of the heated film with the developing solvent to form a patterned film;
(e) heating the patterned film for an amount of time sufficient to form a cured patterned film having a surface;
(f) activating the surface of the cured patterned film and a surface of an adherend;
(g) contacting the activated surface of the cured patterned film with the activated surface of the adherend.

## Patentansprüche

1. Verfahren umfassend:
(i) Fotostrukturierung eines Films aus einer mit Licht bemusterbaren Zusammensetzung durch ein Verfahren, das Aussetzen des Films an Strahlung durch eine Graustufen-Fotomaske umfasst;
(ii) Entfernen der Bereiche des belichteten Films mit einem Entwicklungsfösungsmittel, um einen gemusterten Film mit einer flachen Oberfläche zu bilden;
(iii) Aktivieren der Oberfläche des gemusterten Films, einer Oberfläche eines Fügeteils oder beider und
(iv) In-Berührung-Bringen des Fügeteils mit dem gemusterten Film, um das Fügeteil an den gemusterten Film anzuhaften.

2. Verfahren nach Anspruch 1, wobei die mit Licht bemusterbare Zusammensetzung (a) eine mit Licht bemusterbare Siliconzusammensetzung oder (b) eine organische mit Licht bemusterbare Zusammensetzung umfasst.

3. Verfahren nach Anspruch 1, wobei die mit Licht bemusterbare Zusammensetzung eine mit Licht bemusterbare durch Hydrosilylierung härtbare Siliconzusammensetzung, eine mit Licht bemusterbare epoxyfunktionelle Siliconzusammensetzung, eine (meth)acrylatfunktionelle mit Licht bemusterbare Siliconzusammensetzung, ein (Meth)acrylat, ein Epoxy, einen Cyanatester, ein Polyimid, ein Polybenzoxazol oder ein Benzocyclobuten umfasst.

4. Verfahren nach Anspruch 1, wobei die mit Licht bemusterbare Zusammensetzung eine mit Licht bemusterbare durch Hydrosilylierung härtbare Siliconzusammensetzung umfasst, die enthält:
(A) ein Organopolysiloxan, das durchschnittlich mindestens zwei siliciumgebundene ungesättigte organische Gruppen pro Molekül enthält,
(B) eine Organosiliciumverbindung, die durchschnittlich mindestens zwei siliciumgebundene Wasserstoffe pro Molekül enthält, in einer Konzentration, die ausreicht, um die Zusammensetzung zu härten, und
(C) eine katalytische Menge eines photoaktivierten Hydrosüylierungskatalysators.

5. Verfahren nach Anspruch 4, wobei die Zusammensetzung ferner eines oder mehrere von (D) einem Inhibitor, (E) einem Füller, (F) einem Behandlungsmittel, (G) einer Trägerflüssigkeit, (H) einem Spacer, (I) einem Haftvermittler, (J) einer oberflächenaktiven Substanz, (K) einem Fotosensibilisator, (L) einem Färbemittel oder eine Kombination davon enthält.

6. Verfahren nach Anspruch 1, wobei der Film vor Schritt (i) durch ein Verfahren gebildet wird, das Schleuderbeschichten, Tauchen, Sprühen oder Siebdrucken der mit Licht bemusterbaren Zusammensetzung auf eine Oberfläche eines Substrats umfasst.

7. Verfahren nach Anspruch 6, wobei die Zusammensetzung ferner Komponente (G) eine Trägerflüssigkeit enthält und wobei das Verfahren ferner Entfernen mindestens eines Teils der Komponente (G) aus dem Film vor Schritt (i) umfasst.

8. Verfahren nach Anspruch 1, wobei die Strahlung in Schritt (i) eine Wellenlänge von 150 bis 800 nm aufweist.

9. Verfahren nach Anspruch 1, wobei der belichtete Film belichtete Bereiche, die in dem Entwicklungslösungsmittel im Wesentlichen unlöslich sind, und nichtbelichtete Bereiche, die in dem Entwicklungslösungsmittel löslich sind, aufweist.

10. Verfahren nach Anspruch 1, wobei der belichtete Film belichtete Bereiche, die in dem Entwicklungslösungsmittel löslich sind, und nichtbelichtete Bereiche, die in dem Entwicklungslösungsmittel im Wesentlichen unlöslich sind, aufweist.

11. Verfahren nach Anspruch 1, das ferner das Erwärmen des belichteten Films nach Schritt (i) und vor Schritt (ii) umfasst.

12. Verfahren nach Anspruch 1, das ferner das Erwärmen des gemusterten Films nach Schritt (ii) und vor Schritt (iii) umfasst.

13. Verfahren nach Anspruch 1, wobei Schritt (iii) durch ein Verfahren durchgeführt wird, das Plasmabehandlung, Koronabehandlung, Ozonbehandlung oder Flammbehandlung umfasst.

14. Verfahren nach Anspruch 1, wobei die Oberfläche durch Verwendung von Plasmabehandlung, ausgewählt aus Plasmastrahl, Koronaentladungsbehandlung, dielektrischer Barriereentladungsbehandlung oder Glimmentladungsbehandlung, aktiviert wird.

15. Verfahren nach Anspruch 1, wobei Schritt (iii) Plasmabehandlung der Oberfläche auf dem gemusterten Film umfasst und das Verfahren ferner Plasmabehandlung einer Oberfläche des Fügeteils vor Schritt (iv) umfasst.

16. Produkt erhältlich nach dem Verfahren von Anspruch 1, wobei das Produkt ausgewählt ist aus der Gruppe bestehend aus einem Chip-on-Board-Bauelement, einem Multi-Chip-Modul, einem Einzelchipmodul, einem gestapelten Halbleiterchipmodul, einer Chip-Scale-Package, einer Area-Array-Package, einer Leiterrahmenpackung, eines mikroelektromechanischen Bauelements, eines mikrooptoelektromechanischen Bauelements und eines mikrofluidischen Bauelements.

17. Verfahren nach Anspruch 1, umfassend:
(a) Aufbringen einer mit Licht bemusterbaren Zusammensetzung auf eine Oberfläche eines Substrats, um einen Film zu bilden, wobei die mit Licht bemusterbare Zusammensetzung enthält:
(A) ein Organopolysiloxan, das durchschnittlich mindestens zwei siliciumgebundene ungesättigte organische Gruppen pro Molekül enthält,
(B) eine Organosiliciumverbindung, die durchschnittlich mindestens zwei siliciumgebundene Wasserstoffe pro Molekül enthält, in einer Konzentration, die ausreicht, um die Zusammensetzung zu härten, und
(C) eine katalytisch Menge eines photoaktivierten Hydrosilylierungskatalysators;
(b) Aussetzen eines Teils des Films an Strahlung mit einer Wellenlänge von 150 bis 800 nm durch eine Graustufen-Fotomaske, um einen belichteten Film mit nichtbelichteten Bereichen, die mindestens einen Teil der Oberfläche bedecken, zu erzeugen;
(c) Erwärmen des belichteten Films für einen Zeitraum, sodass die belichteten Bereiche im Wesentlichen in einem Entwicklungslösungsmittel unlöslich sind und die nichtbelichteten Bereiche in dem Entwicklungslösungsmittel löslich sind;
(d) Entfernen der nichtbelichteten Bereiche des erwärmten Films mit dem Entwicklungslösungsmittel, um einen gemusterten Film zu bilden;
(e) Erwärmen des gemusterten Films für einen Zeitraum, der ausreicht, um einen gehärteten gemusterten Film mit einer Oberfläche zu bilden;
(f) Aktivieren der Oberfläche des gehärteten gemusterten Films und einer Oberfläche eines Fügeteils;
(g) In-Berührung-Bringen der aktivierten Oberfläche des gehärteten gemusterten Films mit der aktivierten Oberfläche des Fügeteils.

## Revendications

1. Un procédé comprenant les étapes :
(i) photostructurer un film de composition photostructurable par un procédé comprenant l'exposition du film à une radiation à travers un photomasque à échelle de gris ;
(ii) retirer des zones du film exposé avec un solvant de développement pour former un film à motif possédant une surface plate ;
(iii) activer la surface du film à motif, une surface d'un substrat ou les deux ; et
(iv) mettre en contact le substrat avec le film à motif pour adhérer le substrat au film à motif.

2. Procédé selon la revendication 1, dans lequel la composition photostructurable comprend (a) une composition de silicone photostructurable ou (b) une composition photostructurable organique.

3. Procédé selon la revendication 1, dans lequel la composition photostructurable contient une composition photostructurable de silicone durcissable par réaction d'hydrosilylation, une composition photostructurable de silicone époxy fonctionnelle, une composition photostructurable de silicone (méth)acrylate fonctionnelle, un (méth)acrylate, une époxy, un ester de cyanate, un polyimide, un polybenzoxazole ou un benzocyclobutène,

4. Procédé selon la revendication 1, dans lequel la composition photostructurable comprend une composition photostructurable de silicone durcissable par réaction d'hydrosilylation comprenant :
(A) un organopolysiloxane contenant une moyenne d'au moins deux groupes organiques insaturés liés à un silicium par molécule,
(B) un composé organosilicium contenant une moyenne d'au moins deux atomes d'hydrogène liés à un silicium par molécule dans une concentration suffisante pour polymériser la composition, et
(C) une quantité catalytique d'un catalyseur d'hydrosilylation photoactivé.

5. Procédé selon la revendication 4, dans lequel la composition comprend en outre un ou plusieurs de (D) un inhibiteur, (E) un agent de remplissage, (F) un agent de traitement, (G) un véhicule, (H) un agent d'espacement, (I) un promoteur d'adhérence, (J) un surfactant, (K) un photosensibilisateur, (L) un colorant ou leur combinaison.

6. Procédé selon la revendication 1, dans lequel le film est formé avant l'étape (i) par un procédé comprenant dépôt par rotation, trempage, pulvérisation ou sérigraphie de la composition photostructurable sur une surface d'un substrat.

7. Procédé selon la revendication 6, dans lequel la composition comprend en outre le composant (G), un véhicule, et dans lequel le procédé comprend en outre le retrait d'au moins une partie du composant (G) du film avant l'étape (i).

8. Procédé selon la revendication 1, dans lequel la radiation a une longueur d'onde de 150 à 800 nm à l'étape (i).

9. Procédé selon la revendication 1, dans lequel le film exposé comprend des zones exposées qui sont sensiblement insolubles dans le solvant de développement et des zones non exposées qui sont solubles dans le solvant de développement.

10. Procédé selon la revendication 1, dans lequel le film comprend des zones exposées qui sont solubles dans le solvant de développement et des zones non exposées qui sont sensiblement insolubles dans le solvant de développement.

11. Procédé selon la revendication 1, comprenant en outre le chauffage du film exposé après l'étape (i) et avant l'étape (ii).

12. Procédé selon la revendication 1, comprenant en outre le chauffage du film à motif après l'étape (ii) et avant l'étape (iii).

13. Procédé selon la revendication 1, dans lequel l'étape (iii) est réalisée par un procédé consistant en un traitement sous plasma, un traitement par décharge corona, un traitement à l'ozone ou un traitement par oxydation à la flamme.

14. Procédé selon la revendication 1, dans lequel la surface est activée en utilisant un traitement sous plasma sélectionné parmi un jet plasma, un traitement par décharge corona, un traitement par décharge diélectrique et un traitement par décharge de lumière incandescente.

15. Procédé selon la revendication 1, dans lequel l'étape (iii) comprend le traitement de la surface du film à motif et le procédé comprend en outre le traitement d'une surface du substrat avant l'étape (iv).

16. Produit pouvant être obtenu par le procédé de la revendication 1, le produit étant sélectionne parmi le groupe constitué d'un module puce sur carte, d'un module multipuces, d'un module à puce unique, d'un module à puces empilées, d'un boîtier à l'échelle d'une puce, d'un boîtier matriciel, d'un boîtier de plages de connexion, d'un dispositif microélectromécanique, d'un dispositif microoptoélectromécanique et d'un dispositif microfluidique.

17. Procédé selon la revendication 1, comprenant les étapes de :
(a) à appliquer une composition photostructurable à une surface d'un substrat pour former un film, dans lequel la composition photostructurable comprend :
(A) un organopolysiloxane contenant une moyenne d'au moins deux groupes organiques insaturés liés à un silicium par molécule,
(B) un composé organosilicium contenant une moyenne d'au moins deux atomes d'hydrogène liés à un silicium par molécule en une concentration suffisante pour durcir la composition, et
(C) une quantité catalytique d'un catalyseur d'hydrosilylation photoactivé ;
(b) exposer une partie du film à une radiation ayant une longueur d'onde allant de 150 à 800 nm à travers un photomasque à échelle de gris afin de produire un film exposé possédant des zones non exposées couvrant au moins une partie de la surface ;
(c) chauffer le film exposé pendant une période de temps telle que les zones exposées sont sensiblement insolubles dans le solvant de développement et les zones non exposées sont solubles dans le solvant de développement ;
(d) retirer les zones non exposées du film chauffé avec le solvant de développement pour former un film à motif ;
(e) chauffer le film à motif pendant une période de temps suffisante pour former un film à motif ayant une surface ;
(f) activer la surface du film structuré durci et d'une surface d'un substrat ;
(g) mettre en contact la surface activée du film à motif durci avec la surface activée du substrat.
